# EUROPÄISCHE PATENTSCHRIFT

(11) **EP 4 447 489 B1**
(45) Veröffentlichungstag und Bekanntmachung des Hinweises auf die Patenterteilung: **24.09.2025**
(21) Anmeldenummer: 24197146.4
(22) Anmeldetag: 17.11.2022
(51) Int. Cl.: H04R 19/00

(54) **MEMS-SCHALLWANDLER MIT EINER GEKRÜMMTEN KONTUR EINES KRAGARMELEMENTS**
MEMS SOUND TRANSDUCER WITH A CURVED CONTOUR OF A CANTILEVER ELEMENT
TRANSDUCTEUR ACOUSTIQUE MEMS AVEC UN CONTOUR INCURVÉ D'UN ÉLÉMENT EN PORTE-À-FAUX

(30) Priorität: 17.11.2021 DE 102021130035
(43) Veröffentlichungstag der Anmeldung: 16.10.2024
(62) Teilanmeldung aus: 22207935.2
(73) Patentinhaber: USound GmbH, 8020 Graz (AT)
(72) Erfinder: RUSCONI CLERICI BELTRAMI, Andrea, 1130 Wien (AT); BOTTONI, Ferruccio, 8020 Graz (AT); NOVOTNY, Christian, 1120 Wien (AT); HORVÁTH, Samu Bence, 1020 Wien (AT)
(74) Vertreter: Canzler & Bergmeier Patentanwälte Partnerschaft mbB

(56) Entgegenhaltungen:
- EP-A2- 2 362 686
- DE-A1- 102017 208 911
- JP-A- 2021 052 305
- US-A1- 2012 250 909

## Beschreibung

Die vorliegende Erfindung betrifft einen MEMS-Schallwander zum Erzeugen und/oder Erfassen von Schallwellen mit einem Träger, der eine Kavitätswand aufweist, die zumindest teilweise eine Kavität des MEMS-Schallwandlers begrenzt, und mit zumindest einem Kragarmelement, das einen fest mit dem Träger verbundenen Basisabschnitt und einen über die Kavitätswand überstehenden flexiblen Auslenkabschnitt aufweist, wobei der Auslenkabschnitt ein der Kavitätswand zugewandtes Basisende und ein relativ gegenüber dem Träger in Richtung einer Hubachse des MEMS-Schallwandler auslenkbares freies Ende aufweist.

Aus der EP 2 692 153 A1 ist ein MEMS-Schallwandler bekannt der ein Substrat und eine Vielzahl von mindestens drei benachbarten verjüngten Wandlerbalken umfasst. Jeder Balken umfasst abwechselnde piezoelektrische Schichten und Elektrodenschichten, wobei die piezoelektrischen Schichten derart ausgebildet sind, dass diese einen ausgeübten Druck in eine Spannung umwandeln. Jeder Balken umfasst eine Balkenbasis, eine Balkenspitze und einen zwischen der Balkenbasis und der Balkenspitze angeordneten Balkenkörper, wobei jeder Balken von der Balkenbasis zur Balkenspitze verjüngt ist. Jeder Balken ist entlang der Balkenbasis mit dem Substrat verbunden und entlang seines Balkenkörpers vom Substrat frei. Die Balken sind derart angeordnet, dass die Balkenspitzen der Balken jeweils im Wesentlichen zu einem einzigen Punkt hin zusammenlaufen. Nachteilig bei derartigen MEMS-Schallwandlern ist, dass in den Wandlerbalken bzw. Kragarmelementen lokale Belastungsspitzen auftreten, die bei hohen Leistungen zu einer Zerstörung des Kragarmelements, nämlich insbesondere der piezoelektrischen Wandlerschicht, führen können. Aufgrund dessen müssen bei der Fertigung der MEMS-Schallwandler sehr enge Fertigungstoleranzen eingehalten werden, um die Belastungsspitzen auf einem akzeptablen Niveau zu halten.

Das Dokument JP 2021 052305 A offenbart einen Membranträgerabschnitt mit einer zylindrischen Innerfläche, die einen hohlen Abschnitt bildet, eine Schwingmembran, die mit der Innerfläche über den gesamten Umfang verbunden ist und in Filmdickenrichtung verschoben werden kann, ein piezoelektrisches Element mit einem Elektrodenpaar und einer piezoelektrischen Membran, die zwischen dem Elektrodenpaar angeordnet und auf der Schwingmembran gestapelt ist, und ein Trennschnitz, der den Schwingkörper in Dickenrichtung durchdringt und ihn in mehrere Schwingungsbereiche unterteilt. Die innere Umfangsfläche weist eine polygonale Form auf, bei der mehrere Flächen über abgeschrägte Ecken verbunden sind. Der Trennschnitz weist einen Hauptschlitzabschnitt auf, der sich von der Mitte der Schwingmembran in Richtung der Ecke erstreckt, und einen Unterschlitzabschnitt, der sich von einem Verbindungsabschnitt, der die Ecke und den flachen Abschnitt verbindet, bis zum Ende des Hauptschlitzabschnitt auf der Eckseite erstreckt.

Die Konsequenz sind erhöhte Produktionsausschüsse sowie erhöhte Produktionskosten. Des Weiteren können die bislang bekannten MEMS-Schallwandler aufgrund der lokalen Belastungsspitzen nur bei niedrigen Leistungen betrieben werden.

Aufgabe der vorliegenden Erfindung ist es, die aus dem Stand der Technik bekannten Nachteile zu beseitigen, insbesondere die Leistungsfähigkeit der MEMS-Schallwandler zu erhöhen und/oder den Produktionsausschuss sowie die Produktionskosten zu reduzieren.

Die Aufgabe wird gelöst durch einen MEMS-Schallwandler mit den Merkmalen des unabhängigen Patentanspruchs.

Vorgeschlagen wird ein MEMS-Schallwandler zum Erzeugen und/oder Erfassen von Schallwellen. Der MEMS-Schallwandler kann zum Erzeugen und/oder Erfassen von Schallwellen im hörbaren Wellenlängenspektrum ausgebildet sein. In diesem Fall ist der MEMS-Schallwandler vorzugsweise als Hochtöner ausgebildet und/oder für ein Audiosystem vorgesehen. Zusätzlich oder alternativ kann der MEMS-Schallwandler zum Erzeugen und/oder Erfassen von Schallwellen im Ultraschallbereich ausgebildet sein. In diesem Fall ist der MEMS-Schallwandler vorzugsweise ein Ultraschallsensor und/oder Ultraschallsender. Zusätzlich oder alternativ kann der MEMS-Schallwandler zum Versenden und/oder Empfangen von, insbesondere binären, Daten, die vorzugsweise in Audioinformationen kodiert sind, ausgebildet sein. In diesem Fall ist der MEMS-Schallwandler vorzugsweise Bestandteil einer Datenübertragungseinrichtung.

Der MEMS-Schallwandler umfasst einen Träger, der zumindest eine Kavitätswand aufweist, die zumindest teilweise eine Kavität des MEMS-Schallwandlers begrenzt. Des Weiteren weist der MEMS-Schallwandler zumindest ein Kragarmelement auf, das einen fest mit dem Träger verbundenen Basisabschnitt und einen über die Kavitätswand überstehenden flexiblen Auslenkabschnitt aufweist. Unter dem Begriff "Kragarmelement" ist ein balkenförmiges Element zu verstehen, das ein fest eingespanntes Ende und ein frei schwingendes Ende aufweist. Der Auslenkabschnitt weist ein der Kavitätswand zugewandtes Basisende und ein relativ gegenüber dem Träger in Richtung einer Hubachse des MEMS-Schallwandlers auslenkbares freies Ende auf. Vorgeschlagen wird, dass das Basisende des Auslenkabschnitts in einer Schallwandlerdraufsicht eine gekrümmte erste Kontur aufweist.

Die gekrümmte erste Kontur bewirkt, dass die Belastungen im Auslenkabschnitt, nämlich insbesondere im Bereich des Basisendes, gleichmäßig verteilt werden. Hierdurch kann eine Beschädigung des Kragarmelements aufgrund von lokalen Belastungsspitzen verhindert werden. Durch die gleichmäßige Verteilung der Belastungen in Querrichtung des Kragarmelements können von dem Kragarmelement des Weiteren insgesamt auch höhere Kräfte aufgenommen werden. Infolgedessen kann somit durch die gekrümmte erste Kontur auch die Leistungsfähigkeit des MEMS-Schallwandlers erhöht werden. Des Weiteren werden durch die gekrümmte erste Kontur strukturelle Unterschiede zwischen der Mitte des Kragarmelements und seinen Eckbereichen verringert, was wiederum einen stabileren Betrieb des MEMS-Schallwandlers gewährleistet. Ein weiterer Vorteil der gekrümmten ersten Kontur besteht darin, dass das Kragarmelement, insbesondere sein freies Ende, eine viel sauberere Hubbewegung entlang der Hubachse durchführt. Vorteilhafterweise können hierdurch die Fertigungstoleranzen für den MEMS-Schallwandler erhöht werden. Demnach sind z.B. höhere Ausrichtungsfehler des Kragarmelements gegenüber dem Träger und/oder gegenüber anderen Kragarmelementen tolerierbar. Aufgrund der reduzierten Anforderungen an die Herstellungsgenauigkeit können somit wiederum die Herstellungskosten des MEMS-Schallwandlers reduziert werden.

Zusätzlich oder alternativ zu dem vorstehenden Merkmal - dass das Basisende des Auslenkabschnitts in der Schallwandlerdraufsicht die gekrümmte erste Kontur aufweist - wird vorgeschlagen, dass das freie Ende des Auslenkabschnitts in einer Schallwandlerdraufsicht zwei Ecken aufweist, die vorzugsweise in Querrichtung des freien Endes voneinander beabstandet sind. Vorteilhaft ist es ferner, wenn die beiden Ecken des freien Endes in Querrichtung des Kragarmelements, insbesondere des freien Endes, über eine Endseite miteinander verbunden sind. Vorteilhafterweise kann hierdurch die Leistungsfähigkeit des Kragarmelements im Bereich seines freien Endes verbessert werden.

Vorteilhaft ist es, wenn die Kavitätswand in der Schallwandlerdraufsicht, insbesondere im Bereich des Auslenkabschnitts und/oder zum Auslenkabschnitt benachbart, eine zur ersten Kontur des Auslenkabschnitts korrespondierende gekrümmte zweite Kontur aufweist. Vorzugsweise gibt hierdurch die gekrümmte zweite Kontur der Kavitätswand die gekrümmte Form der ersten Kontur des Auslenkabschnitts vor.

Ebenso ist es vorteilhaft, wenn die erste Kontur eine Positivform und die zweite Kontur eine korrespondierende Negativform bildet.

Auch ist es von Vorteil, wenn die erste Kontur konvex und die zweite Kontur konkav gekrümmt ist. Hierdurch kann eine sehr gute Lastverteilung im Auslenkabschnitt des Kragarmelements sichergestellt werden. Des Weiteren kann durch eine konkave Krümmung der zweiten Kontur das Volumen der Kavität vergrößert werden.

In einer vorteilhaften Weiterbildung der Erfindung ist es vorteilhaft, wenn die gekrümmte erste Kontur als Kurve, insbesondere mit variabler Steigung, und/oder als Polygonzug ausgebildet ist. Unter dem Begriff "Kurve" ist eine glatte, d.h. knickfreie und stufenlose, gekrümmte Kontur zu verstehen. Unter dem Begriff "Polygonzug" ist eine Kontur zu verstehen, die aus einer Vielzahl von Punkten ausgebildet ist, die über gerade Verbindungsstrecken miteinander verbunden sind. Die geraden Verbindungsstrecken weisen zu den jeweils benachbarten Verbindungsstrecken einen Winkel auf und folgen demnach in einem "gröberen Raster" der idealisierten Kurve der ersten gekrümmten Kontur. Der Polygonzug könnte auch gestuft und/oder als diskrete Kurve ausgebildet sein.

Ebenso bringt es Vorteile mit sich, wenn zumindest der Auslenkabschnitt über seine gesamte Länge flexibel und/oder elastisch ausgebildet ist. Infolgedessen erfolgt eine gleichmäßige Biegung des Kragarmelements über die gesamte Länge des vom Träger freien Auslenkabschnitts. Zusätzlich oder alternativ ist es vorteilhaft, wenn sich zumindest der Auslenkabschnitt in der Schallwandlerdraufsicht vom Basisende in Richtung des freien Endes, insbesondere trapez- oder dreieckförmig, verjüngt.

Vorteilhaft ist es zudem, wenn das freie Ende in der Schallwandlerdraufsicht als Rechteckspitze ausgebildet ist, wobei die Seiten der Rechteckspitze vorzugsweise gerade oder gekrümmt ausgebildet sind. Unter dem Begriff "Rechteckspitze" ist eine Spitze des freien Endes zu verstehen, die eine rechteckige Form aufweist. Die zwei Ecken und die Endseite des freien Endes bilden hierbei eine freie Seite dieses Rechtecks. Vorteilhafterweise kann hierdurch in konstruktiv einfacher Weise ein freies Ende mit zwei Ecken ausgebildet werden.

Vorteile bringt es mit sich, wenn das Kragarmelement, insbesondere in Richtung der Hubachse, mehrschichtig ausgebildet ist und zumindest eine, insbesondere flexible, Trägerschicht und eine, insbesondere flexible und/oder piezoelektrische, Wandlerschicht umfasst. Zusätzlich ist es vorteilhaft, wenn das Kragarmelement zumindest eine Elektrodenschicht aufweist. Vorzugsweise ist die zumindest eine piezoelektrische Schicht in einer Querschnittsansicht sandwichartig zwischen zwei Elektrodenschichten angeordnet. Vorteilhaft ist es, wenn sich die Trägerschicht in Längsrichtung des Kragarmelements, insbesondere vollständig, über den Basisabschnitt und den Auslenkabschnitt erstreckt. Zusätzlich oder alternativ ist es vorteilhaft, wenn sich die Wandlerschicht in Längsrichtung des Kragarmelements, insbesondere nur teilweise, über und/oder in den Basisabschnitt und/oder den Auslenkabschnitt erstreckt. Zusätzlich oder alternativ ist es vorteilhaft, wenn sich die Wandlerschicht in Längsrichtung des Kragarmelements vom Auslenkabschnitt in den Basisabschnitt hineinerstreckt. Hierdurch können starke Hubkräfte erzeugt werden. Problematisch ist jedoch, dass hierdurch in der Wandlerschicht im Bereich der Kavitätswand Spannungen entstehen, die zu einer Zerstörung der Wandlerschicht führen können. Diese Spannungen können jedoch wiederum durch die gekrümmte erste Kontur reduziert werden.

Vorteile bringt es zudem mit sich, wenn die Wandlerschicht als Aktorschicht und/oder Sensorschicht ausgebildet ist. Als Aktorschicht dient die Wandlerschicht dazu, den Auslenkabschnitt des Kragarmelements aufgrund einer angelegten Spannung aktiv auszulenken. Als Sensorschicht dient die Wandlerschicht dazu, eine Auslenkung des Auslenkabschnitts des Kragarmelements in eine elektrische Spannung umzuwandeln.

Ebenso bringt es Vorteile mit sich, wenn der Auslenkabschnitt, insbesondere jeweils die Trägerschicht und/oder die Wandlerschicht, in der Schallwandlerdraufsicht eine Dreiecksform aufweist. Zusätzlich oder alternativ ist es vorteilhaft, wenn der Auslenkabschnitt, insbesondere jeweils die Trägerschicht und/oder die Wandlerschicht, zwei in Richtung des freien Endes zueinander zulaufende, vorzugsweise gerade, Längsseiten aufweist. Zusätzlich oder alternativ ist es vorteilhaft, wenn der Auslenkabschnitt, insbesondere jeweils die Trägerschicht und/oder die Wandlerschicht, an dem dem freien Ende abgewandten Ende eine Querseite aufweist. Vorzugsweise erstreckt sich die Querseite in Querrichtung des Kragarmelements und/oder verbindet die beiden Längsseiten miteinander. Die dabei entstehenden Ecken zwischen der Querseite und der jeweiligen Längsseite können abgerundet sein.

Vorteilhaft ist es, wenn die Wandlerschicht in der Schallwandlerdraufsicht kleiner, insbesondere flächenmäßig kleiner, in Querrichtung schmaler und/oder in Längsrichtung kürzer, als die Trägerschicht ausgebildet ist.

Ferner ist es vorteilhaft, wenn in der Schallwandlerdraufsicht die Längsseiten der Wandlerschicht von den Längsseiten der Trägerschicht beabstandet sind, wobei dieser Abstand vorzugsweise über die gesamte Länge konstant ist. Hierdurch kann Material der Wandlerschicht eingespart werden, wodurch die Herstellungskosten für das Kragarmelement reduziert werden können.

Auch ist es von Vorteil, wenn die zumindest eine Längsseite der Wandlerschicht zu der korrespondierenden Längsseite der Trägerschicht parallel ist.

Vorteile bringt es zudem mit sich, wenn die erste Kontur und/oder zweite Kontur zumindest teilweise als ein Kreissegment ausgebildet ist.

Auch ist es von Vorteil, wenn die erste Kontur des Kragarmelements und/oder die zweite Kontur der Kavitätswand in der Schallwandlerdraufsicht mehrere Krümmungsabschnitte mit zueinander unterschiedlichen Krümmungen aufweist. Diesbezüglich ist es ferner vorteilhaft, wenn vorzugsweise die erste Kontur des Kragarmelements und/oder die zweite Kontur der Kavitätswand einen ersten Krümmungsabschnitt mit einer ersten Krümmung und/oder zumindest einen zweiten Krümmungsabschnitt mit einer zweiten Krümmung aufweist.

Ebenso bringt es Vorteile mit sich, wenn die erste und/oder zweite Krümmung als Kreissegment ausgebildet ist. Zusätzlich oder alternativ ist es vorteilhaft, wenn die erste Krümmung im Vergleich zur zweiten Krümmung einen größeren Radius aufweist.

Vorteile bringt es mit sich, wenn ein erster Kreismittelpunkt der ersten Krümmung in der Schallwandlerdraufsicht auf einer Längsmittelachse des Kragarmelements liegt und/oder vom Basisende weiter entfernt ist als das freie Ende. Des Weiteren ist es vorteilhaft, wenn ein zweiter Kreismittelpunkt der zweiten Krümmung in der Schallwandlerdraufsicht auf einer Längsseitenachse des Kragarmelements und/oder zwischen dem Basisende und dem freien Ende liegt.

Auch ist es von Vorteil, wenn der erste Krümmungsabschnitt in der Schallwandlerdraufsicht und/oder in Querrichtung des MEMS-Schallwandlers zwischen zwei zweiten Krümmungsabschnitten angeordnet ist.

Vorteilhaft ist es, wenn der MEMS-Schallwandler mehrere, insbesondere vier, Kragarmelemente aufweist, die vorzugsweise derart zueinander angeordnet sind, dass ihre freien Enden in der Schallwandlerdraufsicht in einem Zentrum der Kavität und/oder des MEMS-Schallwandlers angeordnet sind.

Vorteile bringt es zudem mit sich, wenn die beiden zweiten Krümmungsabschnitte zweier benachbarter Kragarmelemente die gleiche zweite Krümmung aufweisen, so dass diese ein gemeinsames Kreissegment ausbilden.

Vorteile bringt es mit sich, wenn zwei benachbarte Kragarmelemente mit einem Trennschlitz voneinander getrennt sind, wobei sich der Trennschlitz vorzugsweise von einer Kragarmoberseite vollständig zu einer Kragarmunterseite hindurch erstreckt.

Ebenso ist es vorteilhaft, wenn sich der Trennschlitz in der Schallwandlerdraufsicht von den freien Enden der beiden Kragarmelemente ausgehend in Richtung der Kavitätswand erstreckt. Zusätzlich oder alternativ ist es vorteilhaft, wenn ein der Kavitätswand zugewandtes Schlitzende des Trennschlitzes von der Kavitätswand beabstandet ist, so dass die Trägerschichten der beiden benachbarten Kragarmelemente in diesem Bereich verbunden und/oder materialeinteilig ausgebildet sind.

Vorteile bringt es zudem mit sich, wenn der Trennschlitz an seinem Schlitzende einen in Schlitzquerrichtung verlaufenden und/oder gebogenen Entlastungsschlitz aufweist. Hierdurch kann ein Einreißen des Schlitzendes vermieden werden.

Vorteilhaft ist es zudem, wenn mehrere Trennschlitze im Zentrum des MEMS-Schallwandlers einen H-förmigen Trennschlitzbereich ausbilden, der die freien Enden der Kragarmelemente voneinander trennt.

Weitere Vorteile der Erfindung sind in den nachfolgenden Ausführungsbeispielen beschrieben. Es zeigen:
- **Figur 1**: eine Draufsicht eines MEMS-Schallwandlers mit Kragarmelementen, die eine gekrümmte erste Kontur aufweisen,
- **Figur 2**: einen Längsschnitt durch den in Figur 1 dargestellten MEMS-Schallwandler im Bereich eines der Kragarmelemente,
- **Figur 3**: eine Unteransicht des in Figur 1 und 2 dargestellten MEMS-Schallwandlers mit visualisierten Krümmungsgeometrien und
- **Figur 4**: eine Detailansicht des in Figur 1, 2 und 3 dargestellten MEMS-Schallwanders im Bereich eines Zentrums.

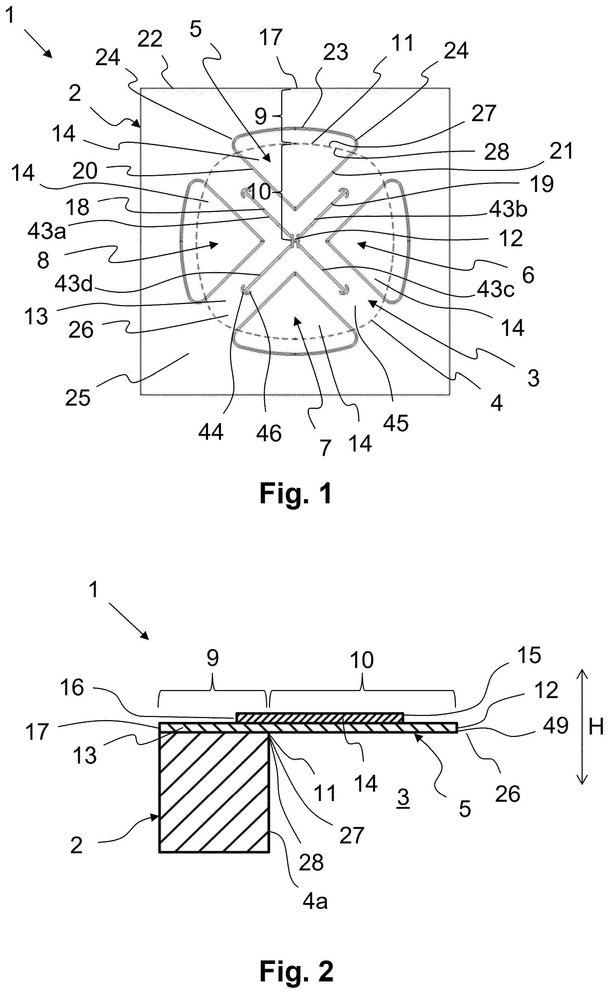

In den Figuren 1 bis 4 ist ein MEMS-Schallwandler 1 zum Erzeugen und/oder Erfassen von Schallwellen gezeigt. Der MEMS-Schallwandler 1 kann zum Erzeugen und/oder Erfassung von Schallwellen im hörbaren Wellenlängenspektrum ausgebildet sein. In diesem Fall ist der MEMS-Schallwandler 1 vorzugsweise als Hochtöner ausgebildet und/oder für ein Audiosystem vorgesehen. Zusätzlich oder alternativ kann der MEMS-Schallwandler 1 zum Erzeugen und/oder Erfassung von Schallwellen im Ultraschallbereich ausgebildet sein. In diesem Fall ist der MEMS-Schallwandler 1 vorzugsweise ein Ultraschallsensor und/oder Ultraschallsender. Zusätzlich oder alternativ kann der MEMS-Schallwandler 1 zum Versenden und/oder Empfangen von Daten, die vorzugsweise in Audioinformationen kodiert sind, ausgebildet sein. In diesem Fall ist der MEMS-Schallwandler 1 vorzugsweise Bestandteil einer Datenübertragungseinrichtung.

Gemäß Figur 1, 2 und 3 umfasst der MEMS-Schallwandler 1 einen Träger 2. Bei dem Träger 2 kann es sich um ein Siliziumsubstrat handeln. Alternativ kann der Träger 2 auch eine PCB-Leiterplatte sein. Des Weiteren umfasst der MEMS-Schallwandler 1 eine Kavität 3. Hierbei handelt es sich um einen akustischen Hohlraum, der vorzugsweise auf einer Rückseite eines akustischen Elements ausgebildet ist, das auf seiner Vorderseite einen Schalldruck erzeugen und/oder erfassen kann.

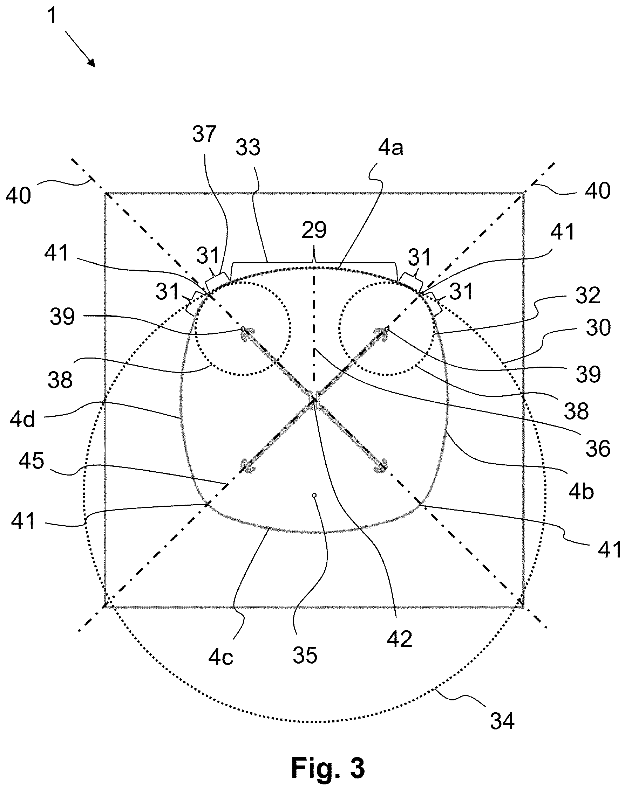

Der Träger 2 weist zumindest eine Kavitätswand 4 auf, die zumindest teilweise die Kavität 3 begrenzt. In dem dargestellten Ausführungsbeispiel umfasst der Träger 2 gemäß Figur 3 mehrere, nämlich insbesondere vier, Kavitätswände 4a, 4b, 4c, 4d. Von diesen sind jeweils zwei zueinander gegenüberliegend angeordnet. Die Kavitätswände 4a, 4b, 4c, 4d bilden somit einen, insbesondere viereckigen und/oder in Umfangsrichtung geschlossenen Rahmen. Zum Erzeugen und/oder Erfassen des Schalldrucks umfasst der MEMS-Schallwandler 1 das zumindest eine akustische Element, das vorliegend als Kragarmelement 5, 6, 7, 8 ausgebildet ist.

Figur 2 zeigt einen Längsschnitt durch ein derartiges Kragarmelement 5, 6, 7, 8, das in Längsrichtung einen Basisabschnitt 9 und einen Auslenkabschnitt 10 umfasst. Im Basisabschnitt 9 ist das Kragarmelement 5, 6, 7, 8 fest mit dem Träger 2 verbunden. Infolgedessen ist das Kragarmelement 5, 6, 7, 8 einseitig, nämlich in seinem Basisabschnitt 9, fest am Träger 2 eingespannt und kann sich in diesem Abschnitt somit relativ gegenüber dem Träger 2 nicht bewegen. Der Auslenkabschnitt 10 ragt im Gegensatz dazu über die Kavitätswand 4 hinaus bzw. steht über die Kavitätswand 4 über. Infolgedessen ist das Kragarmelement 5, 6, 7, 8 in seinem Auslenkabschnitt 10 nicht vom Träger 2 gestützt, so dass das Kragarmelement 5, 6, 7, 8 in diesem Abschnitt über seine Länge gebogen werden kann. Der Auslenkabschnitt 10 umfasst in Längsrichtung des Kragarmelements 5, 6, 7, 8 ein der Kavitätswand 4 zugewandtes Basisende 11 und ein der Kavitätswand 4 abgewandtes freies Ende 12. Das Basisende 11 ist unmittelbar benachbart zur Kavitätswand 4 ausgebildet und weist deshalb eine zur Kavitätswand 4 korrespondierende Form auf. Der gesamte Auslenkabschnitt 10 und insbesondere das freie Ende 12 sind vollständig alleinstehend, d. h. mit keinem weiteren Element verbunden.

Der Auslenkabschnitt 10 des Kragarmelements 5, 6, 7, 8 ist, vorzugsweise über seine gesamte Länge, flexibel ausgebildet, so dass das freie Ende 12 des Auslenkabschnitts 10 bzw. des Kragarmelements 5, 6, 7, 8 durch das Verbiegen des Auslenkabschnitts 10, insbesondere durch ein Verbiegen über die gesamte Länge des Auslenkabschnitts 10, in Richtung einer Hubachse H ausgelenkt werden kann. Dies kann entweder reaktiv aufgrund von eintreffenden Schallwellen oder aber auch aktiv zum Erzeugen von Schallwellen erfolgen.

Wie insbesondere aus Figur 2 hervorgeht, ist das Kragarmelement 5, 6, 7, 8 mehrschichtig ausgebildet. So umfasst das Kragarmelement 5, 6, 7, 8 mehrere in Richtung der Hubachse H übereinanderliegende Schichten. Bei einer dieser Schichten handelt es sich um eine Trägerschicht 13, die vorzugsweise aus einem flexiblen Material, wie beispielsweise Silizium oder einem Polymer, ausgebildet ist. Die Trägerschicht 13 übernimmt hierbei eine tragende Funktion für zumindest eine weitere Schicht. So umfasst das Kragarmelement 5, 6, 7, 8 neben der Trägerschicht 13 ferner zumindest eine Wandlerschicht 14. Mit dieser Wandlerschicht 14 können Schallwellen erfasst und/oder erzeugt werden. Dies erfolgt über eine Wandlung von Bewegungsenergie in Elektrizität und/oder Elektrizität in Bewegungsenergie. Um ausgelenkt werden zu können, ist auch die Wandlerschicht 14, insbesondere über ihre gesamte Länge, flexibel ausgebildet. Bei der Wandlerschicht 14 handelt es sich vorzugsweise um eine piezoelektrische Schicht. Um Schallwellen zu erzeugen, kann die Wandlerschicht 14 demnach als, insbesondere piezoelektrische, Aktorschicht ausgebildet sein. Zusätzlich oder alternativ kann die Wandlerschicht 14 zum Erfassen von Schallwellen als, insbesondere piezoelektrische, Sensorschicht ausgebildet sein. Benachbart zur Wandlerschicht 14 können insbesondere noch zusätzliche Elektronenschichten angeordnet sein.

Gemäß dem in Figur 2 dargestellten Längsschnitt durch eines der Kragarmelemente 5, 6, 7, 8 erstreckt sich die Trägerschicht 13 über die gesamte Länge des Kragarmelements 5, 6, 7, 8. Im Gegensatz dazu ist die Wandlerschicht 14 in Längsrichtung des Kragarmelements 5, 6, 7, 8 kürzer als die Trägerschicht 13 ausgebildet. So ist ein von der Kavitätswand 4 abgewandtes erstes Ende 15 der Wandlerschicht 14 vom freien Ende 12 des Kragarmelements 5, 6, 7, 8 in Längsrichtung des Kragarmelements 5, 6, 7, 8 beabstandet. Ein gegenüberliegendes zweites Ende 16 der Wandlerschicht 14 ist von einem Außenende 17 des Kragarmelements 5, 6, 7, 8 bzw. der Trägerschicht 13 beabstandet. Die Wandlerschicht 14 ist sowohl im Basisabschnitt 9 als auch im Auslenkabschnitt 10 des Kragarmelements 5, 6, 7, 8 angeordnet. Der im Basisabschnitt 9 befindliche Teil der Wandlerschicht 14 ist demnach fest an dem Träger 2 fixiert, so dass dieser nicht gebogen werden kann. Der im Auslenkabschnitt 10 befindliche Teil der Wandlerschicht 14 steht über die Kavitätswand 4 hinaus. Infolgedessen wird dieser bei einer Auslenkung des Auslenkabschnitts 10 über seine, insbesondere gesamte, Länge in Richtung der Hubachse H gebogen.

In der in Figur 1 dargestellten Draufsicht und der in Figur 3 dargestellten kavitätsseitigen Unteransicht des MEMS-Schallwandlers 1 ist zu erkennen, dass sich das Kragarmelement 5, 6, 7, 8 in Richtung des freien Endes 12 verjüngt. So ist das Kragarmelement 5, 6, 7, 8 im Bereich des Basisabschnitts 9 breiter als im Bereich des freien Endes 12 ausgebildet. In dem vorliegenden Ausführungsbeispiel verjüngt sich das Kragarmelement 5, 6, 7, 8 dreieckförmig. Das freie Ende 12 bildet demnach eine in Richtung der Hubachse H frei schwingende Spitze des Kragarmelements 5, 6, 7, 8.

Das Kragarmelement 5, 6, 7, 8 umfasst zwei Längsseiten 18, 19. Gemäß Figur 1 laufen diese in Richtung des freien Endes 12 aufeinander zu. Hierbei sind die beiden Längsseiten 18, 19 gerade ausgebildet. An dem Außenende 17 umfasst das Kragarmelement 5, 6, 7, 8 eine Querseite 22, die vorzugsweise die breiteste Stelle des Kragarmelements 5, 6, 7, 8 bildet. Gemäß der in Figur 1 dargestellten Draufsicht umfasst die Wandlerschicht 14 zu den Längsseiten 18, 19 des Kragarmelements 5, 6, 7, 8 korrespondierende Längsseiten 20, 21. Jedoch ist die Wandlerschicht 14 schmaler als die Trägerschicht 13 ausgebildet, so dass die Längsseiten 20, 21 der Wandlerschicht 14 von den Längsseiten 18, 19 des Kragarmelements 5, 6, 7, 8 beabstandet sind. Vorzugsweise sind die Längsseiten 20, 21 der Wandlerschicht 14 parallel zu den Längsseiten 18, 19 des Kragarmelements 5, 6, 7, 8 ausgebildet. Des Weiteren umfasst die Wandlerschicht 14 auch eine Querseite 23, die am zweiten Ende 16 der Wandlerschicht 14 ausgebildet ist und/oder das zweite Ende 16 bildet. Die Querseite 23 der Wandlerschicht 14 ist gemäß der in Figur 1 dargestellten Draufsicht konvex gekrümmt. Des Weiteren weist die Wandlerschicht 14 zwischen der Querseite 23 und der jeweiligen Längsseite 20, 21 Ecken 24 auf, die vorzugsweise abgerundet sind.

Wie in Figur 1 und 3 dargestellt, umfasst der MEMS-Schallwandler 1 mehrere Kragarmelemente 5, 6, 7, 8. Diese sind gemäß der vorangegangenen Beschreibung ausgebildet. Des Weiteren umfasst der MEMS-Schallwandler 1 mehrere Kavitätswände 4a, 4b, 4c, 4d, die insbesondere in Figur 3 ersichtich sind. Vorzugsweise ist jeder dieser Kavitätswände 4a, 4b, 4c, 4d ein Kragarmelement 5, 6, 7, 8 zugeordnet. Die Kavitätswände 4a, 4b, 4c, 4d begrenzen die Kavität 3 seitlich und/oder bilden einen in Umfangsrichtung geschlossenen Rahmen 25 aus. Der Rahmen 25 ist in Richtung der Hubachse H an zumindest einem Ende offen, so dass eine Rahmenöffnung 26 ausgebildet ist. Die Kragarmelemente 5, 6, 7, 8 sind in Richtung der Hubachse H im Bereich dieser Rahmenöffnung 26 angeordnet und/oder verschließen diese zumindest teilweise.

In dem vorliegenden Ausführungsbeispiel umfasst der MEMS-Schallwandler 1 vier Kragarmelemente 5, 6, 7, 8 und/oder vier Kavitätswände 4a, 4b, 4c, 4d. Die vier Kavitätswände 4a, 4b, 4c, 4d bilden hierbei einen viereckigen, insbesondere quadratischen, Rahmen 25 aus. Zwei Kragarmelemente 5, 6, 7, 8 sind jeweils zueinander gegenüberliegend angeordnet. Infolgedessen befinden sich ihre Basisenden 11 an zwei gegenüberliegenden Kavitätswänden 4a, 4b, 4c, 4d des Rahmens 25.

Wie insbesondere aus Figur 1 und 3 hervorgeht, weist das Basisende 11 des Auslenkabschnitts 10 des zumindest einen Kragarmelements 5, 6, 7, 8 eine gekrümmte erste Kontur 27 auf. Diese erste Kontur 27 ist durch die unmittelbar benachbarte und/oder korrespondierende Kavitätswand 4a, 4b, 4c, 4d definiert. Demnach weist die Kavitätswand 4a, 4b, 4c, 4d gemäß der in Figur 1 und 3 dargestellten Schallwandlerdraufsicht, insbesondere zumindest in einem in Richtung der Hubachse H an den Auslenkabschnitts 10 angrenzenden Bereich, eine zur ersten Kontur 27 des Auslenkabschnitts 10 korrespondierende gekrümmte zweite Kontur 28 auf. Infolgedessen bildet die erste Kontur 27 des Basisendes 11 eine Positivform und die zweite Kontur 28 der Kavitätswand 4a, 4b, 4c, 4d eine dazu korrespondierende Negativform. Die erste Kontur 27 des Basisendes 11 des Kragarmelements 5, 6, 7, 8 ist gemäß Figur 1 und 3 konvex gekrümmt. Die zweite Kontur 28 der Kavitätswand 4a, 4b, 4c, 4d ist konkav gekrümmt.

In dem dargestellten Ausführungsbeispiel ist insbesondere gemäß Figur 1 und 3 die gekrümmte erste Kontur 27 und die gekrümmte zweite Kontur 28 als Kurve ausgebildet. Diese weist eine variable Steigung auf, so dass die Kurve glatt bzw. stufenlos ausgebildet ist. Alternativ könnte die gekrümmte erste Kontur 27 und die gekrümmte zweite Kontur 28 aber auch als Polygonzug ausgebildet sein. In diesem Fall wäre die Krümmung der ersten Kontur 27 und die Krümmung der zweiten Kontur 28 aus einer Vielzahl von Punkten ausgebildet, die über gerade Verbindungsstrecken miteinander verbunden sind. Der Polygonzug könnte auch gestuft bzw. als diskrete Kurve ausgebildet sein.

Wie insbesondere aus Figur 3 hervorgeht, sind die erste Kontur 27 und die korrespondierende zweite Kontur 28 zumindest teilweise als Teil zumindest eines Kreises 34, 38 bzw. als zumindest ein Kreissegment 33, 37 ausgebildet. Die erste Kontur 27 und die korrespondierende zweite Kontur 28 weisen in der in Figur 3 dargestellten Schallwandlerdraufsicht mehrere Krümmungsabschnitte 29, 31 mit zueinander unterschiedlichen Krümmungen 30, 32 auf. So umfasst die erste Kontur 27 und/oder die zweite Kontur 28 einen ersten Krümmungsabschnitt 29, der eine erste Krümmung 30 aufweist. Die erste Krümmung 30 ist als erstes Kreissegment 33 eines ersten Kreises 34 ausgebildet, der einen ersten Kreismittelpunkt 35 aufweist. Der erste Kreismittelpunkt 35 liegt auf einer Längsmittelachse 36 des entsprechenden Kragarmelements 5, 6, 7, 8. Des Weiteren ist der erste Kreismittelpunkt 35 vom Basisende 11 des Auslenkabschnitts 10 weiter entfernt als das freie Ende 12 des MEMS-Schallwandlers 1. Der erste Krümmungsabschnitt 29 erstreckt sich in Querrichtung des Kragarmelements 5, 6, 7, 8 über die gesamte Breite der Wandlerschicht 14.

Wenn die Kavitätswand 4a, 4b, 4c, 4d in der Draufsicht gerade ausgebildet ist, entstehen im Kragarmelement 5, 6, 7, 8 lokale Belastungsspitzen, die zu einer Zerstörung des Kragarmelements 5, 6, 7, 8, nämlich insbesondere der Wandlerschicht 14, führen können. Derartige lokale Belastungsspitzen treten insbesondere im Bereich des Basisendes 11, insbesondere im Bereich der Längsmittelachse 36 des Kragarmelements 5, 6, 7, 8 auf. Die gekrümmte erste Kontur 27 und/oder die zweite Kontur 28 bewirkt, dass die Belastungen im Auslenkabschnitt 10, nämlich insbesondere im Bereich des Basisendes 11, gleichmäßig in Querrichtung des Kragarmelements 5, 6, 7, 8 verteilt werden. Hierdurch kann eine Beschädigung des Kragarmelements 5, 6, 7, 8 aufgrund von Überbelastungen verhindert werden. Durch die gleichmäßige Verteilung der Belastung in Querrichtung können von dem Kragarmelement 5, 6, 7, 8 des Weiteren insgesamt auch höhere Kräfte aufgenommen werden. Infolgedessen kann somit durch die erste Kontur 27 und/oder die zweite Kontur 28 auch die Leistungsfähigkeit des MEMS-Schallwandlers 1 erhöht werden. Des Weiteren werden durch die gekrümmte erste Kontur 27 und/oder die zweite Kontur 28 strukturelle Unterschiede zwischen der Mitte des Kragarmelements 5, 6, 7, 8 und seinen Eckbereichen verringert, wodurch die Kopplung der mit der Wandlerschicht 14 ausgebildeten Bereiche des Kragarmelements 5, 6, 7, 8 mit dem Träger 2 verbessert wird, was wiederum einen stabileren Betrieb des MEMS-Schallwandlers 1 gewährleistet. Ein weiterer Vorteil der gekrümmten ersten Kontur 27 und/oder zweiten Kontur 28 besteht darin, dass das Kragarmelement 5, 6, 7, 8, insbesondere sein freies Ende 12, eine viel sauberere Hubbewegung entlang der Hubachse H durchführt. Vorteilhafterweise können hierdurch die Fertigungstoleranzen für den MEMS-Schallwandler 1 erhöht werden, wodurch wiederum die Herstellungskosten reduziert werden können. Demnach sind z.B. höhere Ausrichtungsfehler des Kragarmelements 5, 6, 7, 8 gegenüber dem Träger 2 und/oder anderen Kragarmelementen 5, 6, 7, 8 aufgrund der gekrümmten ersten Kontur 27 und/oder zweiten Kontur 28 tolerierbar.

Neben dem ersten Krümmungsabschnitt 29 umfasst die erste Kontur 27 und/oder die zweite Kontur 28 gemäß Figur 3 zumindest einen zweiten Krümmungsabschnitt 31, der eine zweite Krümmung 32 aufweist. Die zweite Krümmung 32 ist im Vergleich zu der ersten Krümmung 30 stärker gekrümmt. Die zweite Krümmung 32 ist als ein zweites Kreissegment 37 eines zweiten Kreises 38 ausgebildet, der einen zweiten Kreismittelpunkt 39 aufweist. Der zweite Kreismittelpunkt 39 liegt auf einer Längsseitenachse 40 des Kragarmelements 5, 6, 7, 8. Die Längsseitenachse 40 ist zwischen zwei zueinander in Umfangsrichtung benachbarten Kragarmelementen 5, 6, 7, 8 angeordnet. Der zweite Kreismittelpunkt 39 ist zwischen dem Basisende 11 des Auslenkabschnitts 10 und dem freien Ende 12 des MEMS-Schallwandlers 1 angeordnet. Infolgedessen befindet sich der zweite Kreismittelpunkt 39 im Vergleich zum ersten Kreismittelpunkt 35 näher am Basisende 11. Das zweite Kreissegment 37 weist somit im Vergleich zum ersten Kreissegment 33 einen kleineren Radius auf.

Wie aus Figur 3 hervorgeht, umfasst die erste Kontur 27 und/oder die zweite Kontur 28 zwei zweite Krümmungsabschnitte 31, wobei der erste Krümmungsabschnitt 29 in Querrichtung des Kragarmelements 5, 6, 7, 8 zwischen diesen beiden zweiten Krümmungsabschnitten 31 angeordnet ist.

Die zweite Kontur 28 der korrespondierenden Kavitätswand 4a, 4b, 4c, 4d ist gemäß der vorangegangenen Beschreibung korrespondierend zu der ersten Kontur 27 ausgebildet. Infolgedessen weist die zweite Kontur 28 auch einen ersten Krümmungsabschnitt 29 und zwei seitlich benachbarte zweite Krümmungsabschnitte 31 auf. Hierbei bildet der erste Krümmungsabschnitt 29 im Wesentlichen eine der Kavitätswände 4a, 4b, 4c, 4d. Wie bereits vorstehend erwähnt, umfasst der Träger 2 mehrere solcher Kavitätswände 4a, 4b, 4c, 4d, nämlich gemäß dem vorliegenden Ausführungsbeispiel vier. Zwischen zwei in Umfangsrichtung benachbarten Kavitätswänden 4a, 4b, 4c, 4d ist jeweils eine Kavitätsecke 41 ausgebildet. Gemäß dem vorliegenden Ausführungsbeispiel sind diese Kavitätsecken 41 des Trägers 2 abgerundet. Infolgedessen gehen zwei benachbarte erste Krümmungsabschnitte 29 durch die abgerundete Kavitätsecke 41 fließend ineinander über. Die Rundung der jeweiligen Kavitätsecke 41 ist durch den zugeordneten zweiten Krümmungsabschnitt 31 ausgebildet. Infolgedessen entspricht die Rundung der Kavitätsecken 41 in der Draufsicht der zweiten Krümmung 32. Gemäß Figur 3 sind somit die Kavitätswände 4a, 4b, 4c, 4d des Trägers 2 in der Draufsicht, insbesondere konkav, gekrümmt. Ferner sind die zwischen zwei benachbarten Kavitätswänden 4a, 4b, 4c, 4d ausgebildeten Kavitätsecken 41 abgerundet.

Gemäß Figur 1 und 3 erstrecken sich die Kragarmelemente 5, 6, 7, 8 von den Kavitätswänden 4a, 4b, 4c, 4d des Trägers 2 in Richtung eines Zentrums 42 des MEMS-Schallwandlers 1. Die freien Enden 12 der Kragarmelemente 5, 6, 7, 8 befinden sich somit im Bereich des Zentrums 42. Zwischen zwei benachbarten Kragarmelementen 5, 6, 7, 8 ist jeweils ein Trennschlitz 43a, 43b, 43c, 43d ausgebildet, der die beiden Kragarmelemente 5, 6, 7, 8 voneinander zumindest in einem Bereich trennt. Hierbei erstreckt sich der Trennschlitz 43a, 43b, 43c, 43d vollständig durch alle Schichten des Kragarmelements 5, 6, 7, 8 hindurch, d.h. von einer Kragarmoberseite bis zu einer Kragarmunterseite. Gemäß Figur 1 und 3 erstreckt sich der jeweilige Trennschlitz 43a, 43b, 43c, 43d in der Schallwandlerdraufsicht von den freien Enden 12 der beiden benachbarten Kragarmelemente 5, 6, 7, 8 in Richtung der jeweils korrespondierenden Kavitätswand 4a, 4b, 4c, 4d des Trägers 2. Infolgedessen sind die Kragarmelemente 5, 6, 7, 8 im Bereich ihrer freien Enden 12 vollständig freigeschnitten und/oder voneinander beabstandet. Die Trennschlitze 43a, 43b, 43c, 43d verlaufen hierbei entlang der jeweils korrespondierenden Längsseitenachse 40.

Die Trennschlitze 43a, 43b, 43c, 43d weisen jeweils ein der korrespondierenden Kavitätswand 4a, 4b, 4c, 4d zugewandtes Schlitzende 44 auf. Das Schlitzende 44 ist von der korrespondierenden Kavitätswand 4a, 4b, 4c, 4d, insbesondere in Richtung der Längsseitenachse 40, beabstandet. Infolgedessen sind die Trägerschichten 13 der beiden benachbarten Kragarmelemente 5, 6, 7, 8 in diesem schlitzfreien Bereich miteinander verbunden und materialeinteilig ausgebildet. Vorteilhafterweise wird hierdurch im Bereich der Auslenkabschnitte 10 der Kragarmelemente 5, 6, 7, 8 ein in Umfangsrichtung geschlossener Trägerschichtrand 45 ausgebildet. Dieser verbessert die Stabilität und Robustheit des MEMS-Schallwandlers 1.

Um ein Einreißen im Bereich der Schlitzenden 44 zu vermeiden, weisen die Trennschlitze 43a, 43b, 43c, 43d an ihren Schlitzenden 44 Entlastungsschlitze 46 auf. Diese Entlastungsschlitze 46 verlaufe in Schlitzquerrichtung und sind vorzugsweise gebogen.

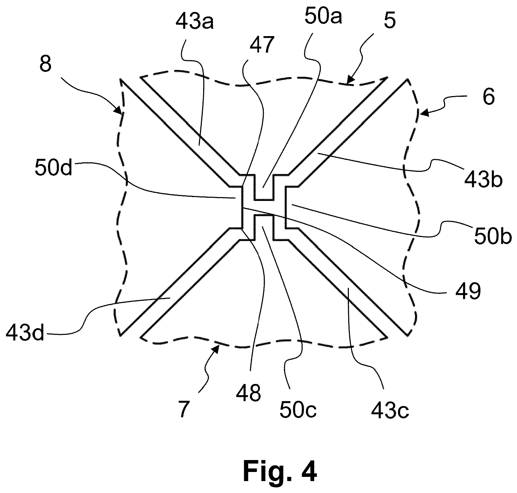

Figur 4 zeigt eine Detailansicht des Zentrums 42 des MEMS-Schallwandlers 1, in der gut zu erkennen ist, dass die freien Enden 12 der Kragarmelemente 5, 6, 7, 8 durch die dazwischen angeordneten Trennschlitze 43a, 43b, 43c, 43d vollständig voneinander getrennt sind. Des Weiteren sind diese auch weder auf ihrer Oberseite noch auf ihrer Unterseite mit zusätzlichen Komponenten verbunden. Infolgedessen sind diese vollständig freigestellte freie Enden 12. Um einen möglichst schmalen Luftspalt zwischen den Kragarmelementen 5, 6, 7, 8, insbesondere zwischen deren freien Enden 12, gewährleisten zu können, weisen die freien Enden 12 in der vorliegend dargestellten Schallwandlerdraufsicht zwei Ecken 47, 48 auf. Die beiden Ecken 47, 48 sind über eine Endseite 49 miteinander verbunden. Die Endseite 49 bildet demnach die Stirnseite des freien Endes 12. Vorzugsweise ist die Endseite 49 gerade ausgebildet. Wie aus Figur 4 hervorgeht, sind die beiden Ecken 47, 48 und die Endseite 49 Bestandteil eines Rechtecks, so dass das freie Ende 12 als Rechteckspitze 50a, 50b, 50c, 50d ausgebildet ist. Um einen möglichst schmalen Luftspalt sicherstellen zu können, sind die Rechteckspitzen 50a, 50c, eines ersten Rechteckspitzenpaars, das zwei Rechteckspitzen 50a, 50c zweier zueinander gegenüberliegender Kragarmelemente 5, 7 umfasst, schmaler ausgebildet als die Rechteckspitzen 50b, 50d eines zweiten Rechteckspitzenpaars. Vorzugsweise ist das erste Rechteckspitzenpaar in der Draufsicht oder Unteransicht gegenüber dem zweiten Rechteckspitzenpaar um 90° versetzt. Des Weiteren sind die schmaleren Rechteckspitzen 50a, 50c des ersten Rechteckspitzenpaars zwischen den beiden Endseiten 49 der Rechteckspitzen 50b, 50d des zweiten Rechteckspitzenpaars angeordnet. Die Trennschlitze 43a, 43b, 43c, 43d sind im Bereich der freien Enden 12 miteinander verbunden, so dass diese einen gemeinsamen zusammenhängenden Trennschlitz ausbilden. Zusammen mit den Rechteckspitzen 50a, 50b, 50c, 50d bilden die Trennschlitze 43a, 43b, 43c, 43d im Zentrum 42 somit einen H-förmigen Trennschlitzbereich aus.

Die vorliegende Erfindung ist nicht auf die dargestellten und beschriebenen Ausführungsbeispiele beschränkt. Abwandlungen im Rahmen der Patentansprüche sind möglich.

### Bezugszeichenliste

- 1: MEMS-Schallwandler
- 2: Träger
- 3: Kavität
- 4: Kavitätswand
- 5: erstes Kragarmelement
- 6: zweites Kragarmelement
- 7: drittes Kragarmelement
- 8: viertes Kragarmelement
- 9: Basisabschnitt
- 10: Auslenkabschnitt
- 11: Basisende
- 12: freies Ende
- 13: Trägerschicht
- 14: Wandlerschicht
- 15: erstes Ende der Wandlerschicht
- 16: zweites Ende der Wandlerschicht
- 17: Außenende
- 18: erste Längsseite des Kragarmelements
- 19: zweite Längsseite des Kragarmelements
- 20: erste Längsseite der Wandlerschicht
- 21: zweite Längsseite der Wandlerschicht
- 22: Querseite des Kragarmelements
- 23: Querseite der Wandlerschicht
- 24: Ecke der Wandlerschicht
- 25: Rahmen
- 26: Rahmenöffnung
- 27: erste Kontur
- 28: zweite Kontur
- 29: erster Krümmungsabschnitt
- 30: erste Krümmung
- 31: zweiter Krümmungsabschnitt
- 32: zweite Krümmung
- 33: erstes Kreissegment
- 34: erster Kreis
- 35: erster Kreismittelpunkt
- 36: Längsmittelachse
- 37: zweites Kreissegment
- 38: zweiter Kreis
- 39: zweiter Kreismittelpunkt
- 40: Längsseitenachse
- 41: Kavitätsecke
- 42: Zentrum
- 43: Trennschlitz
- 44: Schlitzende
- 45: Trägerschichtrand
- 46: Entlastungsschlitze
- 47: erste Ecke des freien Endes
- 48: zweite Ecke des freien Endes
- 49: Endseite
- 50: Rechteckspitze

- H: Hubachse

## Patentansprüche

1. MEMS-Schallwandler (1) zum Erzeugen und/oder Erfassen von Schallwellen
mit einem Träger (2), der eine Kavitätswand (4) aufweist, die zumindest teilweise eine Kavität (3) des MEMS-Schallwandlers (1) begrenzt, und
mit mehreren mehrschichtigen Kragarmelementen (5, 6, 7, 8),
die zumindest eine Trägerschicht (13) umfassen und
die jeweils einen fest mit dem Träger (2) verbundenen Basisabschnitt (9) und einen über die Kavitätswand (4) überstehenden flexiblen Auslenkabschnitt (10) aufweisen,
wobei der Auslenkabschnitt (10) ein der Kavitätswand (4) zugewandtes Basisende (11) und ein relativ gegenüber dem Träger (2) in Richtung einer Hubachse (H) des MEMS-Schallwandlers auslenkbares freies Ende (12) aufweist,
wobei das Basisende (11) des Auslenkabschnitts (10) in einer Schallwandlerdraufsicht eine gekrümmte erste Kontur (27) und die Kavitätswand (4) eine zur ersten Kontur (27) des Auslenkabschnitts (10) korrespondierende gekrümmte zweite Kontur (28) aufweist, und
wobei zwei benachbarte Kragarmelemente (5, 6, 7, 8) mit einem Trennschlitz (43) voneinander getrennt sind, der sich in der Schallwandlerdraufsicht von dem freien Ende (12) der beiden benachbarten Kragarmelemente (5, 6, 7, 8) ausgehend in Richtung der Kavitätswand (4) erstreckt,
**dadurch gekennzeichnet,**
**dass** ein der Kavitätswand (4) zugewandtes Schlitzende (44) des Trennschlitzes (43) von der Kavitätswand (4) beabstandet ist, so dass die Trägerschichten (13) der beiden benachbarten Kragarmelemente (5, 6, 7, 8) in diesem Bereich verbunden sind.

2. MEMS-Schallwandler nach dem vorherigen Anspruch, **dadurch gekennzeichnet, dass** die Kragarmelemente (5, 6, 7, 8) eine, insbesondere piezoelektrische, Wandlerschicht (14) umfassen,
wobei sich vorzugsweise die Trägerschicht (13) in Längsrichtung des Kragarmelements (5, 6, 7, 8), insbesondere vollständig, über den Basisabschnitt (9) und den Auslenkabschnitt (10) erstreckt und/oder wobei sich vorzugsweise die Wandlerschicht (14) in Längsrichtung des Kragarmelements (5, 6, 7, 8), insbesondere nur teilweise, über den Basisabschnitt (9) und/oder den Auslenkabschnitt (10) erstreckt und/oder sich vom Auslenkabschnitt (10) in den Basisabschnitt (9) hineinerstreckt.

3. MEMS-Schallwandler nach einem der vorherigen Ansprüche, **dadurch gekennzeichnet, dass** der Auslenkabschnitt (10), insbesondere jeweils die Trägerschicht (13) und/oder die Wandlerschicht (14), in der Schallwandlerdraufsicht zwei in Richtung des freien Endes (12) zueinander zulaufenden Längsseiten (18, 19; 20, 21) und eine Querseite (22; 23) aufweist.

4. MEMS-Schallwandler nach einem der vorherigen Ansprüche, **dadurch gekennzeichnet, dass** in der Schallwandlerdraufsicht die Längsseiten (20, 21) der Wandlerschicht (14) von den Längsseiten (18, 19) der Trägerschicht (13) beabstandet sind.

5. MEMS-Schallwandler nach einem der vorherigen Ansprüche, **dadurch gekennzeichnet, dass** die erste Kontur (27) des Kragarmelements (5, 6, 7, 8) und/oder die zweite Kontur (28) der Kavitätswand (4) in der Schallwandlerdraufsicht mehrere Krümmungsabschnitte (29, 31) mit zueinander unterschiedlichen Krümmungen (30, 32) aufweist,
wobei vorzugsweise die erste Kontur (27) und/oder die zweite Kontur (28) einen ersten Krümmungsabschnitt (29) mit einer ersten Krümmung (30) und/oder zumindest einen zweiten Krümmungsabschnitt (31) mit einer zweiten Krümmung (32) aufweist.

6. MEMS-Schallwandler nach dem vorherigen Anspruch, **dadurch gekennzeichnet, dass** die erste und/oder zweite Krümmung (30, 32) als Kreissegment (33, 37) ausgebildet ist und/oder die erste Krümmung (30) im Vergleich zur zweiten Krümmung (32) einen größeren Radius aufweist.

7. MEMS-Schallwandler nach einem der Ansprüche 5 oder 6, **dadurch gekennzeichnet, dass** ein erster Kreismittelpunkt (35) der ersten Krümmung (30) in der Schallwandlerdraufsicht auf einer Längsmittelachse (36) des Kragarmelements (5, 6, 7, 8) liegt und/oder vom Basisende (11) weiter entfernt ist als das freie Ende (12).

8. MEMS-Schallwandler nach einem der Ansprüche 5 bis 7, **dadurch gekennzeichnet, dass** ein zweiter Kreismittelpunkt (39) der zweiten Krümmung (32) in der Schallwandlerdraufsicht auf einer Längsseitenachse (40) des Kragarmelements (5, 6, 7, 8) und/oder zwischen dem Basisende (11) und dem freien Ende (12) liegt.

9. MEMS-Schallwandler nach einem der Ansprüche 5 - 8, **dadurch gekennzeichnet, dass** der erste Krümmungsabschnitt (29) in der Schallwandlerdraufsicht und/oder in Querrichtung des MEMS-Schallwandlers (1) zwischen zwei zweiten Krümmungsabschnitten (31) angeordnet ist.

10. MEMS-Schallwandler nach einem der vorherigen Ansprüche, **dadurch gekennzeichnet, dass** die freien Enden (12) der Kragarmelemente (5, 6, 7, 8) in der Schallwandlerdraufsicht in einem Zentrum (42) des MEMS-Schallwandlers (1) angeordnet sind.

11. MEMS-Schallwandler nach einem der vorherigen Ansprüche, **dadurch gekennzeichnet, dass** der Trennschlitz (43) an seinem Schlitzende (44) einen in Schlitzquerrichtung verlaufenden und/oder gebogenen Entlastungsschlitz (46) aufweist.

12. MEMS-Schallwandler nach einem der vorherigen Ansprüche, **dadurch gekennzeichnet, dass** das freie Ende (12) in der Schallwandlerdraufsicht als Rechteckspitze (50) ausgebildet ist und/oder dass mehrere Trennschlitze (43) im Zentrum (42) des MEMS-Schallwandlers (1) einen H-förmigen Trennschlitzbereich ausbilden, der die freien Enden (12) der Kragarmelemente (5, 6, 7, 8) voneinander trennt.

## Claims

1. MEMS sound transducer (1) for generating and/or detecting sound waves
having a support (2) which has a cavity wall (4) which at least partially delimits a cavity (3) of the MEMS sound transducer (1), and
having multiple multi-layered cantilever arm elements (5, 6, 7, 8), which comprise at least one support layer (13) and
which each have a base section (9) which is fixedly connected to the support (2) and a flexible deflection section (10) which projects beyond the cavity wall (4),
wherein the deflection section (10) has a base end (11) which faces the cavity wall (4) and a free end (12) which can be deflected relative to the support (2) in the direction of a reciprocation axis (H) of the MEMS sound transducer,
wherein the base end (11) of the deflection section (10) has a curved first contour (27) in a sound transducer top view and the cavity wall (4) has a curved second contour (28) which corresponds to the first contour (27) of the deflection section (10), and
wherein two adjacent cantilever arm elements (5, 6, 7, 8) are separated from one another by a separating slot (43) which, in the sound transducer top view, extends from the free end (12) of the two adjacent cantilever arm elements (5, 6, 7, 8) in the direction of the cavity wall (4),
**characterized in that**
a slot end (44) of the separating slot (43) which faces the cavity wall (4) is spaced apart from the cavity wall (4), with the result that the support layers (13) of the two adjacent cantilever arm elements (5, 6, 7, 8) are connected in this region.

2. MEMS sound transducer according to the preceding claim, **characterized in that** the cantilever arm elements (5, 6, 7, 8) comprise a, in particular piezoelectric, transducer layer (14),
wherein the support layer (13) preferably extends, in particular completely, over the base section (9) and the deflection section (10) in the longitudinal direction of the cantilever arm element (5, 6, 7, 8) and/or wherein the transducer layer (14) preferably extends, in particular only partially, over the base section (9) and/or the deflection section (10) in the longitudinal direction of the cantilever arm element (5, 6, 7, 8) and/or extends from the deflection section (10) into the base section (9).

3. MEMS sound transducer according to one of the preceding claims, **characterized in that** the deflection section (10), in particular in each case the support layer (13) and/or the transducer layer (14), has, in the sound transducer top view, two longitudinal sides (18, 19; 20, 21) which taper towards one another in the direction of the free end (12) and a transverse side (22; 23).

4. MEMS sound transducer according to one of the preceding claims, **characterized in that**, in the sound transducer top view, the longitudinal sides (20, 21) of the transducer layer (14) are spaced apart from the longitudinal sides (18, 19) of the support layer (13).

5. MEMS sound transducer according to one of the preceding claims, **characterized in that** the first contour (27) of the cantilever arm element (5, 6, 7, 8) and/or the second contour (28) of the cavity wall (4) has, in the sound transducer top view, multiple curvature sections (29, 31) with curvatures (30, 32) which differ from one another,
wherein the first contour (27) and/or the second contour (28) preferably has a first curvature section (29) with a first curvature (30) and/or at least one second curvature section (31) with a second curvature (32).

6. MEMS sound transducer according to the preceding claim, **characterized in that** the first and/or second curvature (30, 32) is formed as a circle segment (33, 37) and/or
the first curvature (30) has a larger radius in comparison with the second curvature (32).

7. MEMS sound transducer according to either of Claims 5 or 6, **characterized in that** a first circle center (35) of the first curvature (30) lies, in the sound transducer top view, on a longitudinal central axis (36) of the cantilever arm element (5, 6, 7, 8) and/or is further away from the base end (11) than the free end (12).

8. MEMS sound transducer according to one of claims 5 to 7, **characterized in that** a second circle center (39) of the second curvature (32) lies, in the sound transducer top view, on a longitudinal side axis (40) of the cantilever arm element (5, 6, 7, 8) and/or between the base end (11) and the free end (12).

9. MEMS sound transducer according to one of claims 5 to 8, **characterized in that** the first curvature section (29) is arranged, in the sound transducer top view and/or in the transverse direction of the MEMS sound transducer (1), between two second curvature sections (31).

10. MEMS sound transducer according to one of the preceding claims, **characterized in that** the free ends (12) of the cantilever arm elements (5, 6, 7, 8) are arranged, in the sound transducer top view, in a center (42) of the MEMS sound transducer (1).

11. MEMS sound transducer according to one of the preceding claims, **characterized in that** the separating slot (43) has, at its slot end (44), a relief slot (46) which runs and/or is curved in the slot transverse direction.

12. MEMS sound transducer according to one of the preceding claims, **characterized in that** the free end (12) is formed, in the sound transducer top view, as a rectangular tip (50) and/or
multiple separating slots (43) form, in the center (42) of the MEMS sound transducer (1), an H-shaped separating slot region which separates the free ends (12) of the cantilever arm elements (5, 6, 7, 8) from one another.

## Revendications

1. Transducteur acoustique MEMS (1) pour générer et/ou détecter des ondes acoustiques
comprenant un support (2) qui comporte une paroi de cavité (4) qui délimite au moins partiellement une cavité (3) du transducteur acoustique MEMS (1), et
comprenant plusieurs éléments de porte-à-faux multicouches (5, 6, 7, 8),
qui comprennent au moins une couche de support (13) et
qui comportent chacun une section de base (9) solidaire du support (2) et une section de déviation flexible (10) dépassant de la paroi de cavité (4),
la section de déviation (10) comportant une extrémité de base (11) tournée vers la paroi de cavité (4) et une extrémité libre (12) déflectible par rapport au support (2) dans la direction d'un axe de levage (H) du transducteur acoustique MEMS,
l'extrémité de base (11) de la section de déviation (10) comportant, en vue de dessus du transducteur acoustique, un premier contour incurvé (27) et la paroi de cavité (4) comportant un deuxième contour incurvé (28) correspondant au premier contour (27) de la section de déviation (10), et
deux éléments de porte-à-faux voisins (5, 6, 7, 8) étant séparés l'un de l'autre par une fente de séparation (43) qui s'étend, en vue de dessus du transducteur acoustique, à partir de l'extrémité libre (12) des deux éléments de porte-à-faux voisins (5, 6, 7, 8) dans la direction de la paroi de cavité (4),
**caractérisé en ce**
**qu'**une extrémité de fente (44) de la fente de séparation (43) tournée vers la paroi de cavité (4) est espacée de la paroi de cavité (4) de sorte que les couches de support (13) des deux éléments de porte-à-faux voisins (5, 6, 7, 8) sont reliées dans cette zone.

2. Transducteur acoustique MEMS selon la revendication précédente, **caractérisé en ce que** les éléments de porte-à-faux (5, 6, 7, 8) comprennent une couche de transducteur (14), en particulier piézoélectrique,
la couche de support (13) s'étendant de préférence dans la direction longitudinale de l'élément de porte-à-faux (5, 6, 7, 8), en particulier complètement, sur la section de base (9) et la section de déviation (10) et/ou
la couche de transducteur (14) s'étendant de préférence dans la direction longitudinale de l'élément de porte-à-faux (5, 6, 7, 8), en particulier seulement partiellement, sur la section de base (9) et/ou la section de déviation (10) et/ou s'étendant de la section de déviation (10) dans la section de base (9).

3. Transducteur acoustique MEMS selon l'une des revendications précédentes, **caractérisé en ce que** la section de déviation (10), en particulier respectivement la couche de support (13) et/ou la couche de transducteur (14), comporte, en vue de dessus du transducteur acoustique, deux côtés longitudinaux (18, 19 ; 20, 21) convergeant l'un vers l'autre dans la direction de l'extrémité libre (12) et un côté transversal (22 ; 23).

4. Transducteur acoustique MEMS selon l'une des revendications précédentes, **caractérisé en ce que**, en vue de dessus du transducteur acoustique, les côtés longitudinaux (20, 21) de la couche de transducteur (14) sont espacés des côtés longitudinaux (18, 19) de la couche de support (13).

5. Transducteur acoustique MEMS selon l'une des revendications précédentes, **caractérisé en ce que** le premier contour (27) de l'élément de porte-à-faux (5, 6, 7, 8) et/ou le deuxième contour (28) de la paroi de cavité (4) comportent, en vue de dessus du transducteur acoustique, plusieurs sections de courbure (29, 31) avec des courbures (30, 32) différentes l'une de l'autre,
le premier contour (27) et/ou le deuxième contour (28) comportant de préférence une première section de courbure (29) avec une première courbure (30) et/ou au moins une deuxième section de courbure (31) avec une deuxième courbure (32).

6. Transducteur acoustique MEMS selon la revendication précédente, **caractérisé en ce que** la première et/ou la deuxième courbure (30, 32) est réalisée sous forme de segment circulaire (33, 37) et/ou la première courbure (30) présente un rayon plus grand que la deuxième courbure (32).

7. Transducteur acoustique MEMS selon l'une des revendications 5 ou 6, **caractérisé en ce qu'**un premier centre du cercle (35) de la première courbure (30) se situe, en vue de dessus du transducteur acoustique, sur un axe médian longitudinal (36) de l'élément de porte-à-faux (5, 6, 7, 8) et/ou est plus éloigné de l'extrémité de base (11) que l'extrémité libre (12).

8. Transducteur acoustique MEMS selon l'une des revendications 5 à 7, **caractérisé en ce qu'**un deuxième centre du cercle (39) de la deuxième courbure (32) se situe, en vue de dessus du transducteur acoustique, sur un axe des côtés longitudinaux (40) de l'élément de porte-à-faux (5, 6, 7, 8) et/ou entre l'extrémité de base (11) et l'extrémité libre (12).

9. Transducteur acoustique MEMS selon l'une des revendications 5 à 8, **caractérisé en ce que** la première section de courbure (29) est disposée, en vue de dessus du transducteur acoustique et/ou dans la direction transversale du transducteur acoustique MEMS (1), entre deux deuxièmes sections de courbure (31).

10. Transducteur acoustique MEMS selon l'une des revendications précédentes, **caractérisé en ce que** les extrémités libres (12) des éléments de porte-à-faux (5, 6, 7, 8) sont disposées, en vue de dessus du transducteur acoustique, dans un centre (42) du transducteur acoustique MEMS (1).

11. Transducteur acoustique MEMS selon l'une des revendications précédentes, **caractérisé en ce que** la fente de séparation (43) comporte, à son extrémité de fente (44), une fente de décharge (46) s'étendant dans la direction transversale de la fente et/ou courbée.

12. Transducteur acoustique MEMS selon l'une des revendications précédentes, **caractérisé en ce que** l'extrémité libre (12) est réalisée, en vue de dessus du transducteur acoustique, sous forme de pointe rectangulaire (50) et/ou
que plusieurs fentes de séparation (43) forment, au centre (42) du transducteur acoustique MEMS (1), une zone de fente de séparation en forme de H qui sépare les extrémités libres (12) des éléments de porte-à-faux (5, 6, 7, 8) les unes des autres.
